# EUROPÄISCHE PATENTANMELDUNG

(11) **EP 0 786 784 A1**
(43) Veröffentlichungstag der Anmeldung: **30.07.1997**
(21) Anmeldenummer: 96116982.8
(22) Anmeldetag: 23.10.1996
(51) Int. Cl.: H01F 27/28, H01F 41/04

(54) **Spule und Verfahren zur Herstellung von Spulen**

(30) Priorität: 25.01.1996 DE 19602614
(71) Anmelder: ROBERT BOSCH GMBH, 70442 Stuttgart (DE)
(72) Erfinder: Alf, Reinhard, 12103 Berlin (DE)

(57) **Zusammenfassung**

Es wird eine Spule und ein Verfahren zur Herstellung von Spulen vorgeschlagen. Die Spule weist mindestens eine Leiterbahn auf, die mäanderförmig auf einem faltbaren, isolierenden Trägermaterial aufgebracht ist. Das Trägermaterial ist so gefaltet, daß die mindestens eine Leiterbahn Windungen mit gleicher Windungsrichtung bildet. Im Trägermaterial sind weiterhin Durchbrüche vorsehbar, die von den Mäandern der mindestens einen Leiterbahn jeweils halbseitig umschlossen sind und im gefalteten Zustand des Trägermaterials eine durchgehende Öffnung zur Aufnahme eines Spulenkerns bilden. Das Verfahren sieht vor, mindestens eine Leiterbahn mäanderförmig auf ein faltbares, isolierendes Trägermaterial aufzubringen und das Trägermaterial so zu falten, daß die mindestens eine Leiterbahn Windungen mit gleicher Windungsrichtung bildet.

## Beschreibung

### Stand der Technik

Die Erfindung geht von einer Spule bzw. einem Verfahren zur Herstellung von Spulen nach der Gattung der unabhängigen Ansprüche aus.

Aus der DE OS 23 58 398 sind dünne Flachspulen mit möglichst kleinen Abmesssungen und eng aneinanderliegenden Windungen bekannt, bei denen eine elektrisch leitende Folie einseitig mit einer Isolierschicht und einer Klebemittelschicht oder einer elektrisch isolierenden Klebemittelschicht beschichtet ist und das entstandene Laminat auf einem Dorn fest zu einer Rolle aufgewickelt ist. Ein in der genannten Offenlegungsschrift beschriebenes Verfahren sieht vor, eine größere Rolle nach Abbinden der Klebemittelschicht in scheibenförmige Flachspulen vorbestimmter Stärke mittels einer Guillotineschere, einer diamantbeschichteten Trennscheibe oder eines Metalldrahtes zu zertrennen und den beim Zertrennen entstandenen Grat oder Metallstaub durch mechanisches Polieren oder (elektro-) chemisches Behandeln von den Trennflächen zu entfernen.

Aus der DE OS 25 29 922 und der DE OS 23 30 302 sind weiterhin Vorrichtungen zum Wickeln von Spulen bekannt, mit denen drahtförmiges Material auf einen Spulenkörper aufgewickelt wird.

### Vorteile der Erfindung

Die erfindungsgemäße Spule mit den Merkmalen des unabhängigen Anspruchs 1 hat demgegenüber den Vorteil, daß sie auch bei flacher Bauhöhe nicht spiralförmig ist und daher einen geringeren Platzbedarf, insbesondere beim Aufbringen auf eine Platine erfordert.

Als weiterer Vorteil ist anzusehen, daß die Herstellung der erfindungsgemäßen Spule wenig Aufwand erfordert, da weder Vorrichtungen zum Wickeln der Spule erforderlich sind, noch die Verwendung einer Klebemittelschicht oder die Entfernung eines Grates oder von Metallstaub notwendig ist.

Die Herstellung der erfindungsgemäßen Spule erfolgt hingegen einfach durch Abschneiden einer faltbaren Endloswicklung und ist daher vorteilhafterweise besonders kostengünstig realisierbar.

Besonders vorteilhaft ist auch, daß eine exakte Aufbringung einer Leiterbahn auf das an genau definierbaren Stellen faltbare Trägermaterial möglich ist und auf diese Weise winzige Induktivitäten hochpräzise und reproduzierbar herstellbar sind.

Durch die in den Unteransprüchen aufgeführten Maßnahmen sind vorteilhafte Weiterbildungen und Verbesserungen der im unabhängigen Anspruch 1 angegebenen Spule möglich.

Besonders vorteilhaft ist, daß Anschluß- und Anzapfkontakte einer Leiterbahn im gefalteten Zustand des Trägermaterials auf einfache Weise über Falzflächen an den Rändern des Trägermaterials zugänglich sind.

Von Vorteil ist außerdem, daß auf einem Trägermaterial mehrere Leiterbahnen aufbringbar sind und so mehrere Spulen bei unverändertem Platzbedarf realisierbar sind.

Ein weiterer Vorteil besteht darin, daß nicht alle Leiterbahnen auf dem Trägermaterial gleiche Länge aufweisen müssen, so daß auf einfache Weise unterschiedlich definierte Induktivitäten auf einem Trägermaterial realisierbar sind.

### Zeichnung

Ausführungsbeispiele der Erfindung sind in der Zeichnung dargestellt und in der nachfolgenden Beschreibung näher erläutert. Es zeigen Figur 1 eine Leiterbahn auf einem ebenen Trägermaterial, Figur 2 eine schematische Darstellung des Faltvorgangs, Figur 3 zwei Leiterbahnen unterschiedlicher Länge auf einem ebenen Trägermaterial und Figur 4 eine Spule mit Spulenkern.

### Beschreibung der Ausführungsbeispiele

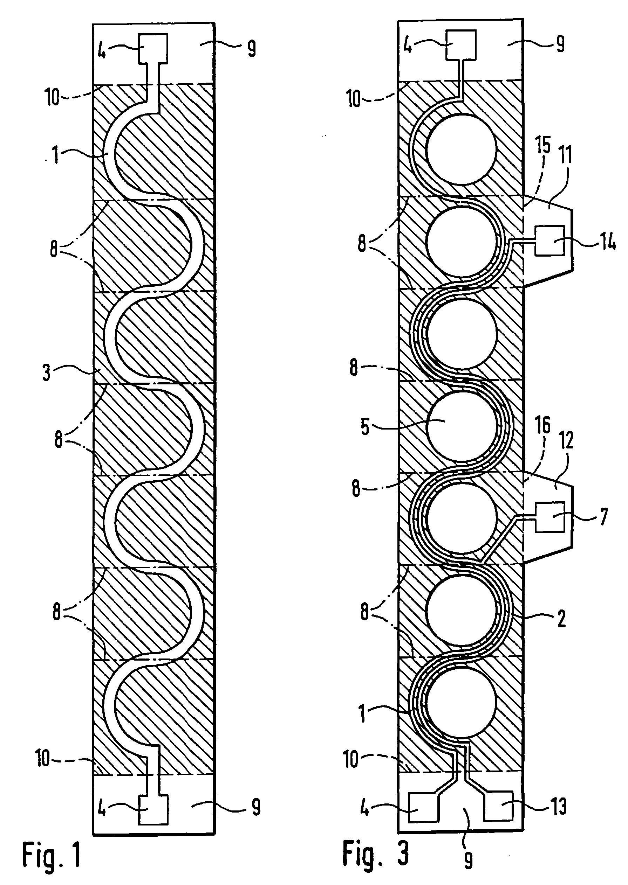

In Figur 1 kennzeichnet 3 ein rechteckig-bandförmiges, isolierendes, flexibles, faltbares Trägermaterial, das parallel zu seinen kurzen Seitenbegrenzungen äquidistante Faltkanten 8 aufweist, wobei der Abstand der kurzen Seitenbegrenzungen zu der jeweils benachbarten Faltkante 8 größer als der Abstand benachbarter Faltkanten 8 untereinander ist. Die kurzen Seitenbegrenzungen stellen faltbare Falzkanten 10 zwischen dem Trägermaterial 3 und jeweils einer benachbarten, isolierenden Falzfläche 9 dar. Die Falzflächen 9 setzen den bandförmigen Verlauf des Trägermaterials 3 für jeweils ein kurzes Stück zur Aufnahme je eines Anschlußkontaktes 9 fort. Die Anschlußkontakte 9 sind jeweils mit einem Ende einer mäanderförmigen ersten Leiterbahn 1 verbunden, deren Mäander Halbkreise sind und die dem Bandverlauf folgend auf das Trägermaterial 3 aufgebracht ist. Der Durchmesser der Halbkreise entspricht dabei dem Abstand der Faltkanten 8 untereinander. Die Leiterbahn 1 ist zudem so auf das Trägermaterial 3 aufgebracht, daß die Übergänge zwischen zwei benachbarten halbkreisförmigen Mäandern der ersten Leiterbahn 1 jeweils mit einer Faltkante 8 zusammenfallen. Die Breite des bandförmigen Trägermaterials 3 ist größer als der Durchmesser der halbkreisförmigen Mäander, so daß die erste Leiterbahn 1 nicht mit dem Rand des Trägermaterials 3 in Berührung kommt.

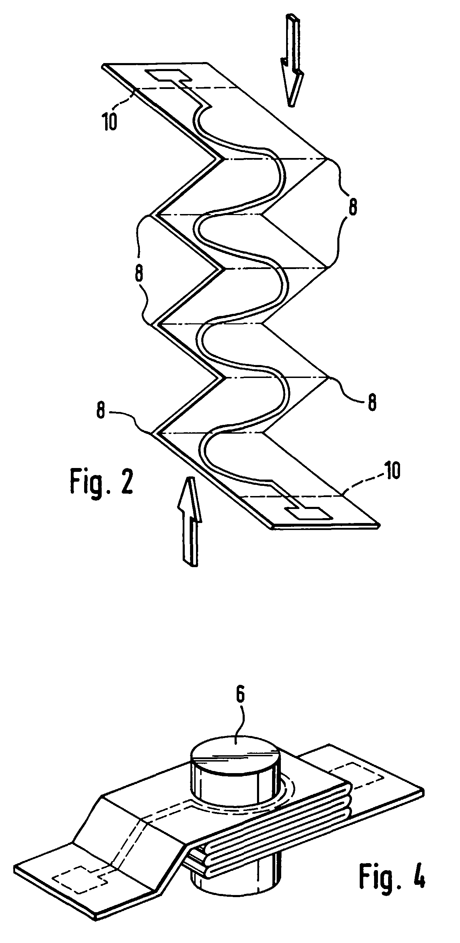

Nach dem Aufbringen der ersten Leiterbahn 1 auf das Trägermaterial 3 wird das Trägermaterial 3 - wie in Figur 2 dargestellt - an den Faltkanten 8 zickzackförmig gefaltet und in Pfeilrichtung zusamengedrückt, so daß die erste Leiterbahn 1 Windungen mit gleicher Windungsrichtung und somit eine einlagige Spule mit gleicher Wickelrichtung bildet.

Ein weiteres Ausführungsbeispiel zeigt Figur 3. Im Unterschied zu Figur 1 ist parallel zur ersten Leiterbahn 1 verlaufend und galvanisch von ihr getrennt eine zweite Leiterbahn 2 auf das Trägermaterial 3 aufgebracht. Die zweite Leiterbahn 2 beginnt dabei wie die erste Leiterbahn 1 mit ihrem ersten Anschlußkontakt 13 auf einer der beiden Falzflächen 9. Sie ist jedoch um 1 1/2 Halbkreise kürzer als die erste Leiterbahn 1, so daß ihr zweiter Anschlußkontakt 14 auf einer über eine dritte faltbare Falzkante 15 mit der der zweiten Leiterbahn 2 zugewandten Längsseite des Trägermaterials 3 verbundenen dritten isolierenden Falzfläche 11 aufgebracht ist. Die dritte Falzfläche 11 bildet dabei eine Fortsetzung des entsprechenden durch zwei benachbarte Faltkanten 8 gebildeten Segments des Trägermaterials 3. Auf gleiche Weise ist nach zwei Halbkreisen vom ersten Anschlußkontakt 13 der zweiten Leiterbahn 2 aus betrachtet von dieser ein Anzapfkontakt 7 auf eine über eine vierte faltbare Falzkante 16 mit der der zweiten Leiterbahn 2 zugewandten Längsseite des Trägenmaterials 3 verbundenen vierten isolierenden Falzfläche 12 geführt. Auch die vierte Falzfläche 12 bildet dabei eine Fortsetzung des entsprechenden, durch zwei benachbarte Faltkanten 8 gebildeten Segments des Trägermaterials 3. Die Lage der Anschluß- und Anzapfkontakte auf Falzflächen an den Rändern des Trägermaterials ermöglicht einen einfachen Zugang von außen zu diesen Kontakten.

Schließlich sind in Figur 3 entlang einer Geraden im Trägermaterial 3 kreisförmige Durchbrüche 5 gleichen Durchmessers vorgesehen, deren Mittelpunkte äquidistant auf der Geraden liegen und die von den Mäandern der beiden Leiterbahnen 1 und 2 halbseitig bzw. halbkreisförmig umschlossen sind, ohne daß eine der beiden Leiterbahnen 1, 2 mit einem Durchbruch 5 in Berührung kommt.

Faltet man das Trägermaterial wie in Figur 2, so erhält man im Fall der Anordnung nach Figur 3 eine Primär- und eine Sekundärspule mit unterschiedlicher Windungszahl und Anzapfung. In gefaltetem Zustand bilden die Durchbrüche 5 zudem eine durchgehende Öffnung zur Aufnahme eines Spulenkerns 6, wie in Figur 4 am Beispiel einer einzigen Wicklung nach Figur 1 dargestellt ist. Wie in Figur 4 angedeutet, sind Ausführungsformen mit faltbaren Falzflächen möglich, so daß ein optimierter Zugang zu den Anschluß- und Anzapfkontakten ermöglicht wird.

Weitere Ausführungsformen sehen mehr als zwei parallel verlaufende Leiterbahnen auf einer Seite des Trägermaterials 3 vor. Weiterhin ist auch die Aufbringung von Leiterbahnen auf beiden Seiten des Trägermaterials möglich.

## Patentansprüche

1. Spule, insbesondere Hochfrequenz- oder Koppelspule, dadurch gekennzeichnet, daß mindestens eine Leiterbahn (1, 2) mäanderförmig auf einem faltbaren, isolierenden Trägermaterial (3) aufgebracht ist und daß das Trägermaterial (3) so gefaltet ist, daß die mindestens eine Leiterbahn (1, 2) Windungen mit gleicher Windungsrichtung bildet.

2. Spule nach Anspruch 1, dadurch gekennzeichnet, daß zwei mit jeweils einem Leiterbahnende der mindestens einen Leiterbahn (1, 2) verbundene Anschlußkontakte (4, 13, 14) jeweils auf einer mit dem Trägermaterial (3) verbundenen Falzfläche (9, 11) aufgebracht sind.

3. Spule nach Anspruch 1 oder 2, dadurch gekennzeichnet, daß das Trägermaterial (3) Durchbrüche (5) aufweist, die von den Mäandern der mindestens einen Leiterbahn (1, 2) jeweils halbseitig umschlossen sind und im gefalteten Zustand des Trägermaterials (3) eine durchgehende Öffnung zur Aufnahme eines Spulenkerns (6) bilden.

4. Spule nach einem der vorherigen Ansprüche, dadurch gekennzeichnet, daß auf beiden Seiten des Trägermaterials (3) mindestens eine Leiterbahn (1, 2) aufgebracht ist.

5. Spule nach einem der vorherigen Ansprüche, dadurch gekennzeichnet, daß mehrere galvanisch getrennte Leiterbahnen (1, 2) parallel zueinander auf einer Seite des Trägermaterials (3) aufgebracht sind.

6. Spule nach einem der vorherigen Ansprüche, dadurch gekennzeichnet, daß Leiterbahnen (1, 2) unterschiedlicher Länge auf dem Trägermaterial (3) aufgebracht sind.

7. Spule nach einem der vorherigen Ansprüche, dadurch gekennzeichnet, daß mindestens ein mit einer Leiterbahn (1, 2) verbundener Anzapfkontakt (7) auf einer mit dem Trägermaterial (3) verbundenen Falzfläche (12) aufgebracht ist.

8. Spule nach einem der vorherigen Ansprüche, dadurch gekennzeichnet, daß das Trägermaterial (3) an vorgegebenen Faltkanten (8) gefaltet ist.

9. Verfahren zur Herstellung von Spulen, dadurch gekennzeichnet, daß mindestens eine Leiterbahn (1, 2) mäanderförmig auf ein faltbares, isolierendes Trägermaterial (3) aufgebracht wird und daß das Trägermaterial (3) so gefaltet wird, daß die mindestens eine Leiterbahn (1, 2) Windungen mit gleicher Windungsrichtung bildet.

10. Verfahren nach Anspruch 9, dadurch gekennzeichnet, daß zwei mit jeweils einem Leiterbahnende der mindestens einen Leiterbahn (1, 2) verbundene Anschlußkontakte (4, 13, 14) jeweils auf eine mit dem Trägermaterial (3) verbundene Falzfläche (9, 11) aufgebracht werden.
